Europäisches Patentamt

European Patent Office

Office européen des brevets

(11) Veröffentlichungsnummer: **0 151 269**
A1

# (12) EUROPÄISCHE PATENTANMELDUNG

(21) Anmeldenummer: 84115057.6

(22) Anmeldetag: 10.12.84

(51) Int. Cl.⁴: **H 05 K 7/02**
H 02 B 1/10

(30) Priorität: 27.01.84 DE 3402826

(43) Veröffentlichungstag der Anmeldung:
14.08.85 Patentblatt 85/33

(84) Benannte Vertragsstaaten:
AT CH DE IT LI SE

(71) Anmelder: Siemens Aktiengesellschaft
Berlin und München Wittelsbacherplatz 2
D-8000 München 2(DE)

(72) Erfinder: Weissberger, Günther
Giselastrasse 11
D-8420 Kelheim(DE)

(72) Erfinder: Hertel, Rudolf
Dechbettener Weinberg 3
D-8400 Regensburg(DE)

(54) Elektrisches Installationsgerät, insbesondere zur Übertragung von Information über Installationsleitungen.

(57) Elektrisches Installationsgerät, insbesondere zur Übertragung von Information über Installationsleitungen. Erfindungsgemäß ist vorgesehen, daß ein Geräterahmen (1) sowohl zur Aufnahme von Bedieneinheit (2) und Geräteeinheit (3) als auch von Abdeckrahmen (5) und Abdeckplatten (6, 7) von der Vorderseite her ausgebildet ist, an dessen Rückseite Tragarme (8) mit Halterungen für modulartige Bauelementeträger (9) angeordnet sind.

FIG 1

EP 0 151 269 A1

Siemens Aktiengesellschaft

Berlin und München

Unser Zeichen
VPA **84 P 3021 E**

Elektrisches Installationsgerät, insbesondere zur Übertragung von Information über Installationsleitungen

Die Erfindung bezieht sich auf ein elektrisches Installationsgerät, insbesondere zur Übertragung von Information über Installationsleitungen. Ein solches Installationsgerät kann insbesondere als Wechselsprechgerät ausgebildet sein, wo ein Gerät in einem Zimmer eines Hauses in der Steckdose angeschlossen ist und ein weiteres Gerät in einem anderen Zimmer an der Steckdose des Installationsnetzes angeschlossen ist. Bei mehreren derartigen Geräten kann durch eine Kanalwahl an einem bestimmten Gerät zum Wechselsprechen aufgefordert werden.

Derartige Geräte sind auf dem Markt. Sie stellen in aller Regel Sonderkonstruktionen dar, die in einem Gehäuse angeordnet sind, das auch tragende Funktionen übernimmt.

Der Erfindung liegt die Aufgabe zugrunde, ein elektrisches Installationsgerät zu entwickeln, das elektronische Bauelemente, wie sie beispielsweise zur Übertragung von Information über Installationsleitungen erforderlich sind, zusammen mit Bedieneinheit und Geräteeinheit in einer gemeinsamen Tragstruktur unter Berücksichtigung des jeweiligen Anwendungszwecks wahlweise anzuordnen gestattet.

Die Lösung der geschilderten Aufgabe besteht nach der Erfindung darin, daß ein Gerätetragrahmen sowohl zur Aufnahme von Bedieneinheit und Geräteeinheit als auch

No 2 Rat / 19.01.1984

von Abdeckrahmen und Abdeckplatten von der Vorderseite her ausgebildet ist, an dessen Rückseite Tragarme mit Halterungen für modulartige Bauelementeträger angeordnet sind. Ein derartiges Installationsgerät weist eine selbsttragende Struktur auf, die es gestattet, das im wesentlichen fertigmontierte Gerät in ein Tischgehäuse mit Anschlußleitung oder in handelsübliche Installationsdosen mit 58 mm Durchmesser unter Putz zu installieren.

Hierzu ist es günstig, wenn der Gerätetragrahmen Befestigungslöcher jeweils passend zu den Halteschrauben einer marktüblichen Installationsdose aufweist. Das Installationsgerät kann in einer Anreihung von nebeneinander angeordneten marktüblichen Installationsdosen untergebracht werden, wenn die Tragorgane hinsichtlich des von ihnen umschlossenen Haltefeldes sowie die Bedieneinheit und die Geräteeinheit in ihren Abmessungen auf eine der bei Unterputzinstallation üblichen Abmessungen eines Einzelfeldes abgestimmt sind. Bei einer Wechselsprechanlage, bei der eine Bedieneinheit mit Mikrofon und eine Wiedergabeeinheit mit einem Lautsprecher genügt, kann das Installationsgerät dann in zwei üblichen Unterputzdosen untergebracht werden.

Es ist günstig, wenn der Gerätetragrahmen Ausnehmungen für Führungsnasen des Abdeckrahmens aufweist, um diesen sicher, gegebenenfalls formschlüssig nach Art von Nut und Feder zu führen.

Der Gerätetragrahmen kann eines von Befestigungsmittel-Paaren nach Art von Loch und Schraube oder von Schnapploch und Schnappkralle für die Bedieneinheit und für die Geräteeinheit sowie für die Abdeckplatten dieser Einheiten aufweisen. Dadurch können diese Bauteile leicht am Gerätetragrahmen befestigt werden.

Es ist günstig, für die Abdeckplatten von Geräteeinheit und Bedieneinheit einen Toleranzausgleich vorzusehen. Hierzu kann man an den Abdeckplatten abstehende federnde Zungen anformen, die unbelastet über die Auflagefläche an den Abdeckplatten vorstehen, mit denen die Abdeckplatten auf dem Abdeckrahmen aufliegen. Dadurch wird zugleich vermieden, daß es in der Abdeckung der Gerätebauteile zu Klappergeräuschen kommen könnte.

Es ist vorteilhaft, die Bedieneinheit aus einer Frontplatte mit Bedienelementen nach Art von Drucktasten und/oder Schiebern zu bilden, die mit angeformtem federnden Haltearmen eine Platine in zugeordneten Ausnehmungen hält, auf der den Bedienelementen zugeordnete mechanisch-elektrische Wandlerelemente angeordnet sind. Dadurch wird bei freier künstlerischer Gestaltung der Frontseite es möglich, die günstigsten elektronischen Wandler oder Bauelemente zu nutzen und eine funktionssichere Bedieneinheit vorzufertigen.

Vorteilhafterweise werden die Tragarme mit Halterungen für mehr als einen modulartigen Bauelementeträger versehen. Die Halterungen können hierbei Führungsdorne und/oder Greifnoppen bilden, um in mehreren Ebenen Bauelementeträger anordnen zu können.

Die Erfindung soll nun anhand eines in der Zeichnung schematisch wiedergegebenen Ausführungsbeispiels näher erläutert werden:

In Fig. 1 ist ein elektrisches Installationsgerät in der Ausführung als Wechselsprechgerät bei abgenommenen Deckplatten wiedergegeben, das in ein Gehäuse, beispielsweise ein Tischgehäuse, eingesetzt ist.

In Fig. 2 ist das Installationsgerät nach Fig. 1 bei aufgesetzten Abdeckplatten veranschaulicht.

In Fig. 3 ist das Installationsgerät nach Fig. 2 in perspektivischer Darstellung und mit einer Anschlußleitung versehen dargestellt.

In Fig. 4 ist das Installationsgerät nach Fig. 1 im Längsschnitt wiedergegeben, wobei die Frontseite unten senkrecht zur Zeichenebene liegt. Die Geräteeinheit und die Bedieneinheit sind in dieser Darstellung entfernt.

In Fig. 5 ist das Installationsgerät nach Fig. 4 in Ansicht auf die Frontseite veranschaulicht, wobei in der Zeichenebene oberhalb des Gerätetragrahmens eine Platine mit der den Bedienelementen zugeordneten mechanisch elektrischen Wandlerelementen veranschaulicht ist. Die Platine kann an den abgeschnitten wiedergegebenen Verbindungsleitungen in den Tragrahmen hineingehoben werden.

In Fig. 6 ist das Installationsgerät nach Fig. 4 in Ansicht von unten dargestellt.

In Fig. 7 ist eine Frontplatte der Bedieneinheit dargestellt, die zusammen mit der Platine mit den mechanisch-elektrischen Wandlerelementen nach Fig. 5 zusammengesteckt werden kann.

In Fig. 8 ist die Frontplatte des Bedienelementes nach Fig. 7 in Ansicht auf den Schnitt längs VIII-VIII nach Fig. 7 dargestellt.

In Fig. 9 ist eine Abdeckplatte für eine als Lautsprecher ausgebildete Geräteeinheit veranschaulicht.

In Fig. 10 ist die Abdeckplatte nach Fig. 9 in Seitenansicht wiedergegeben.

In Fig. 11 ist ein Ausführungsbeispiel für die Abdeckplatte eines als Wechselsprechgerät ausgebildeten Installationsgerätes in Ansicht von vorn dargestellt.
In Fig. 12 ist die Abdeckplatte nach Fig. 11 in Seitenansicht wiedergegeben.
In Fig. 13 ist ein Ausschnitt der Ansicht auf die Längsseite des in einem Gehäuse eingesetzten Installationsgerätes nach Fig. 1 veranschaulicht.
In Fig. 14 ist das Installationsgerät nach Fig. 13 in Ansicht auf die Schmalseite, teilweise geschnitten, wiedergegeben.

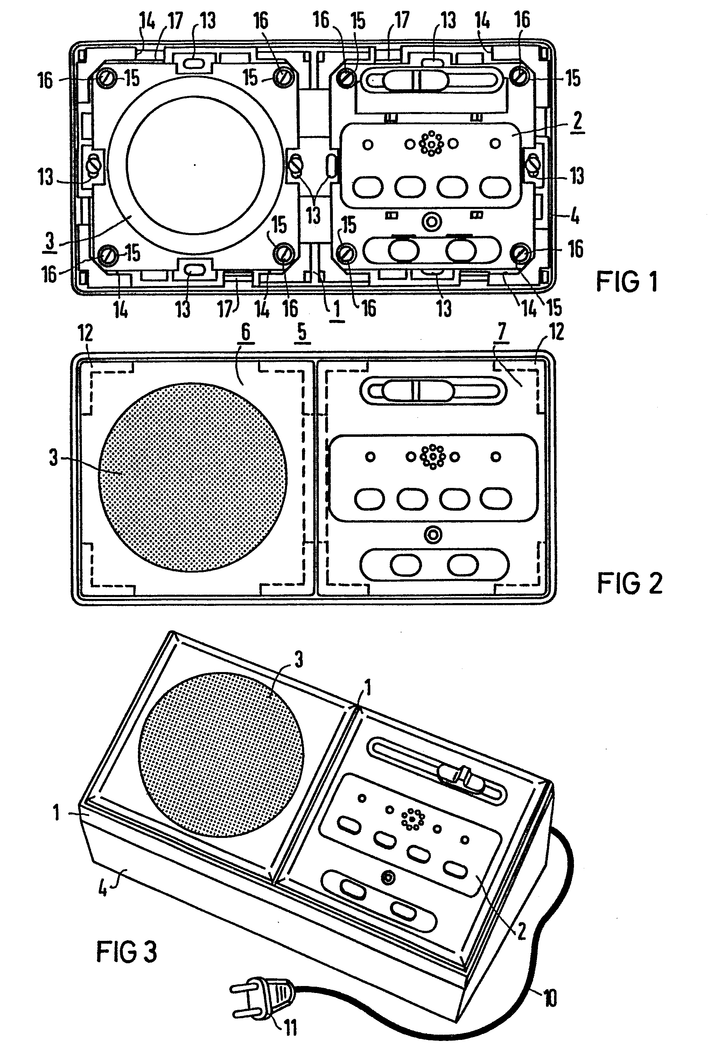

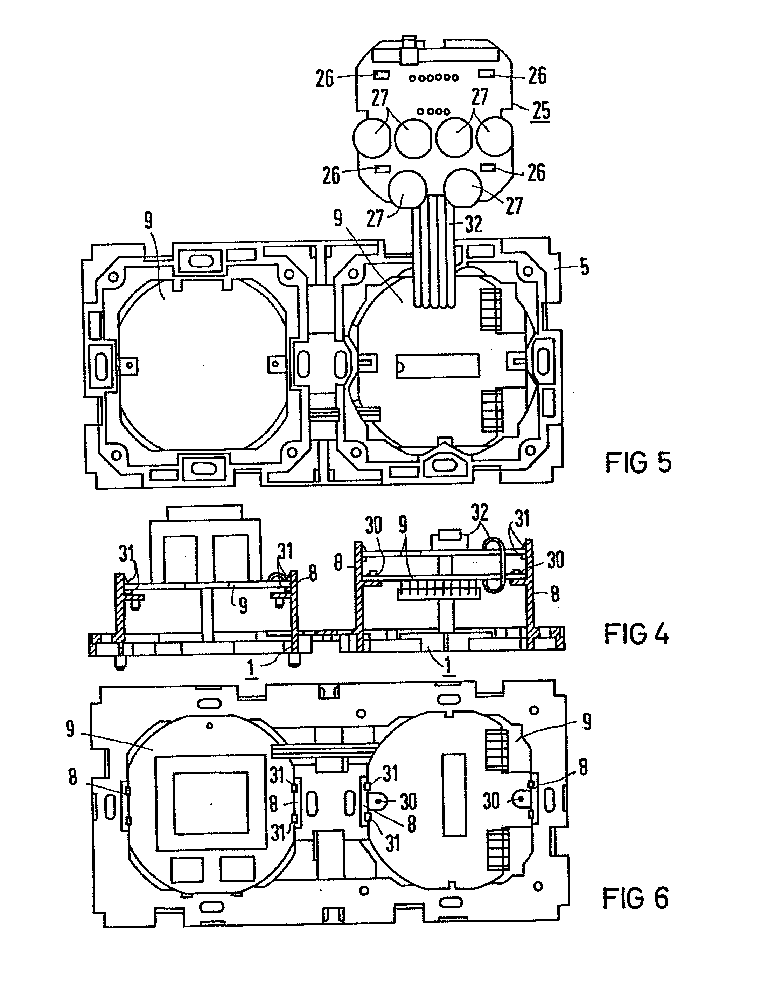

Das elektrische Installationsgerät in der Ausführung als Wechselsprechgerät nach Fig. 1 weist einen Gerätetragrahmen 1 mit zwei Feldern auf. Das in der Zeichnung rechte Feld nimmt die Bedieneinheit 2 und das linke Feld die Geräteeinheit 3, im Ausführungsbeispiel einen Lautsprecher, von der Vorderseite her auf. Der Gerätetragrahmen 1, der alle wesentlichen Elemente des Installationsgerätes aufnimmt, ist in einem Gehäuse 4 eingesetzt. Der Gerätetragrahmen 1 nimmt auch einen Abdeckrahmen 5, wie er bei Installationssystemen üblich ist, und Abdeckplatten 6 und 7 für die Geräteeinheit und die Bedieneinheit auf, wie es in Fig. 2 dargestellt ist. An der Rückseite des Gerätetragrahmens 1 nach Fig. 4 sind Tragarme 8 ausgebildet, die Halterungen für modulartige Bauelementeträger 9 aufweisen. In Fig. 3 ist ein Installationsgerät in der Ausführung als ein Wechselsprechgerät in Tischausführung in perspektivischer Ansicht wiedergegeben. Mit einer Anschlußleitung 10 und einem Stecker 11 kann es an einer üblichen Installationssteckdose angeschlossen werden.

Das Installationsgerät nach Fig. 4 weist Tragarme auf, die hinsichtlich des von ihnen umschlossenen Haltefeldes in ihren Abmessungen auf eine der bei Unterputzinstallationen üblichen Abmessungen abgestimmt sind. Ebenso sind die Bedieneinheit und die Geräteeinheit, die in Fig. 4 nicht wiedergegeben sind, auf dieses Rastermaß abgestimmt. Das Installationsgerät kann dadurch mit einem Gerätetragrahmen 1 in zwei nebeneinander angeordneten für Unterputzinstallation üblichen Installationsdosen eingesetzt werden.

Der Gerätetragrahmen 1 nach Fig. 1 weist Befestigungslöcher 13 auf, für jedes Feld passend zu den Halteschrauben einer marktüblichen Installationsdose. Der Gerätetragrahmen 1 bildet weiter Ausnehmungen 14 für Führungsnasen 12 der jeweiligen Abdeckrahmen.

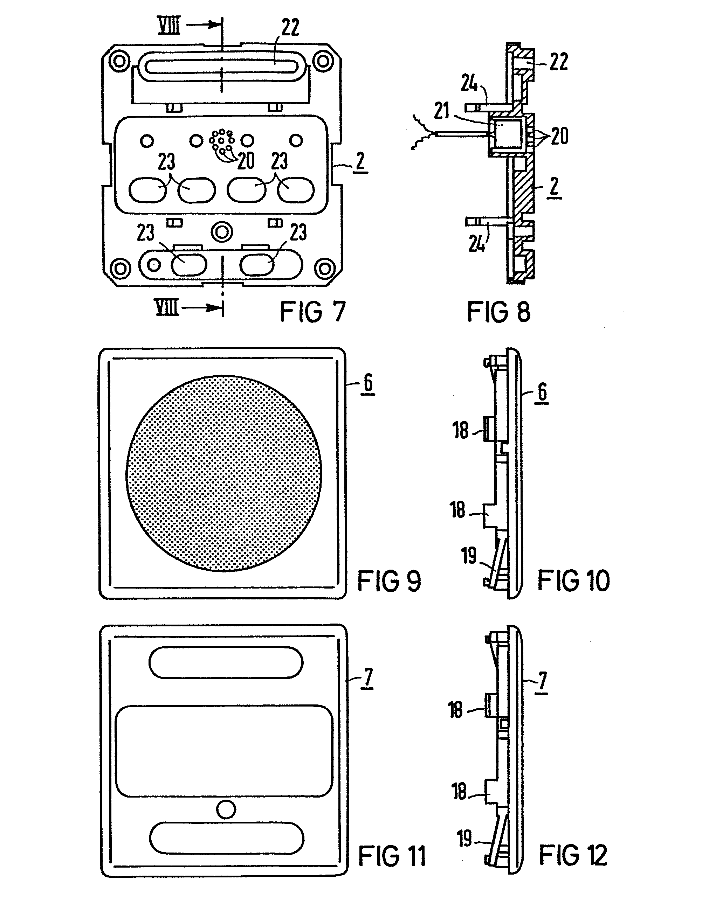

Der Gerätetragrahmen 1 nach Fig. 1 weist Befestigungslöcher 15 als eines des Befestigungsmittel-Paares Schraube und Loch auf, in das Schrauben 16 zum Befestigen der Bedieneinheit 2 und der Geräteeinheit 3 eingeführt sind. Der Gerätetragrahmen 1 weist außer den Befestigungsmittel-Paaren nach Art von Schnapploch und Schnappkralle oder von Loch und Schraube Ausnehmungen 17 für Schnappkrallen 18 der Abdeckplatten 6 und 7 nach den Figuren 10 bzw. 12, für die Geräteeinheit 3 und für die Bedieneinheit 2 auf.

An den Abdeckplatten 6 und 7 nach den Figuren 9 und 10 bzw. 11 und 12 sind abstehende federnde Zungen 19 angeformt, man vergleiche Figuren 10 und 12, die unbelastet über die Auflagefläche der Abdeckplatten vorstehen, mit denen die Abdeckplatten auf dem Abdeckrahmen 5 nach Fig. 2 aufliegen. Dadurch wird bei Toleranzausgleich ein Klappern in der gesamten Abdeckung vermieden. Die Abdeckplatten können in ihrer Ebene um 90° versetzt werden, um eine waagrechte oder vertikale Geräteausrichtung zu ermöglichen.

Die Frontplatte der Bedieneinheit 2 nach Fig. 7 hat Ausnehmungen 20 für den Schalldurchtritt zu einem Mikrofon 21 nach Fig. 8. In der Ausnehmung 22 für einen Lautstärkeregler kann ein Betätigungsglied für einen Schieber eingesetzt werden. Der Betrieb und die Kanäle zu anderen Geräten können durch Drucktasten 23 gesteuert werden. Vorteilhafterweise sind an der Frontplatte für die Bedieneinheit 2 nach Fig. 7 federnde Haltearme 24 ausgebildet, die eine Platine 25 nach Fig. 5 in zugeordneten Ausnehmungen 26 hält. Auf der Platine 25 sind den Bedienelementen, dem Schieber in der Ausnehmung 22 und den Drucktasten 23 nach Fig. 7 zugeordnete mechanisch-elektrische Wandlerelemente 27 angeordnet.

Die Tragarme 8 nach den Figuren 4 bis 6 weisen Halterungen für mehr als einen modulartigen Bauelementeträger 9 auf. Diese Halterungen sind im Ausführungsbeispiel als Führungsdorne 30 und als jeweils paarweise zusammenwirkende Greifnoppen 31 ausgebildet. In Fig. 5 sieht man auf die oberste Ebene der Bauelementeträger 9 und in Fig. 6 auf der rechten Seite auf den untersten Bauelementeträger. Leitungsverbindungen sind mit 32 veranschaulicht. Die Bestückung mit elektronischen Bauelementen kann den jeweiligen Erfordernissen entsprechend in an sich bekannter Weise erfolgen.

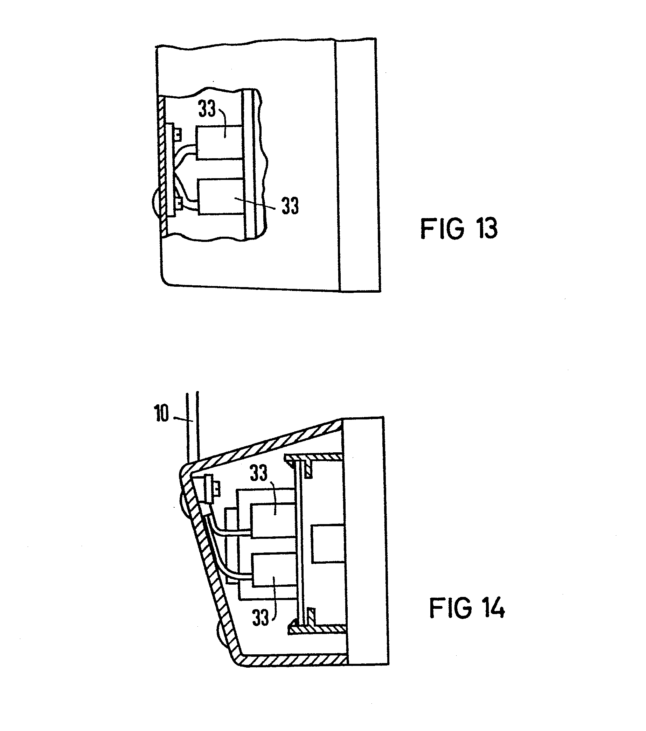

In den Figuren 13 und 14 ist ein Ausschnitt in der Ansicht auf die Längsseite des Installationsgerätes nach Fig. 1 bzw. eine Ansicht der Schmalseite des aufgeschnittenen Gehäuses des Installationsgerätes nach Fig. 1 für ein Tischgerät als Ausführungsbeispiel veranschaulicht. Eine Anschlußleitung ist abgebrochen mit 10 bezeichnet wiedergegeben. Zwei Versorgungsleitungen, die zugleich die Informationen vom und zum Installationsgerät weitergeben, können in schraubenlosen
Klemmen 33 angeschlossen sein. Der Informationsaustausch
zwischen solchen Installationsgeräten erfolgt üblicherweise in Trägerfrequenz.

9 Patentansprüche
14 Figuren

Patentansprüche

1. Elektrisches Installationsgerät, insbesondere zur Übertragung von Information über Installationsleitungen, d a d u r c h   g e k e n n z e i c h n e t, daß ein Gerätetragrahmen (1) sowohl zur Aufnahme von Bedieneinheit (2) und Geräteeinheit (3) als auch von Abdeckrahmen (5) und Abdeckplatten (6, 7) von der Vorderseite her ausgebildet ist, an dessen Rückseite Tragarme (8) mit Halterungen für modulartige Bauelementeträger (9) angeordnet sind.

2. Elektrisches Installationsgerät nach Anspruch 1, d a d u r c h   g e k e n n z e i c h n e t, daß der Gerätetragrahmen (1) Befestigungslöcher (13) jeweils passend zu den Halteschrauben einer marktüblichen Installationsdose aufweist.

3. Installationsgerät nach Anspruch 1, d a d u r c h   g e k e n n z e i c h n e t, daß der Gerätetragrahmen (1) Ausnehmungen (14) für Führungsnasen (12) des Abdeckrahmens aufweist (Fig. 2).

4. Installationsgerät nach Anspruch 1, d a d u r c h   g e k e n n z e i c h n e t, daß die Tragarme (8) hinsichtlich des von ihnen umschlossenen Haltefeldes sowie die Bedieneinheit (2) und die Geräteeinheit (3) in ihren Abmessungen auf eine der bei Unterputzinstallation üblichen Abmessungen eines Einzelfeldes abgestimmt sind, so daß das Installationsgerät in einem Verbund von Unterputz-Installationsdosen einbaubar ist.

5. Installationsgerät nach Anspruch 1, d a d u r c h   g e k e n n z e i c h n e t, daß der Gerätetragrahmen (1) eines von Befestigungsmittel-Paaren nach Art von

0151269

Loch (15) und Schraube (16) oder von Schnapploch und
Schnappkralle aufweist und daß jeweils das andere der
Befestigungsmittel-Paare der Bedieneinheit (2) und
der Geräteeinheit (3) zugeordnet ist.

6. Installationsgerät nach Anspruch 1, d a d u r c h
g e k e n n z e i c h n e t, daß der Gerätetragrahmen
(1) eines von Befestigungsmittel-Paaren nach Art von
Schnapploch (Ausnehmungen 17) und Schnappkralle oder
von Loch und Schraube aufweist und daß das jeweils
andere des Befestigungsmittel-Paares den Abdeckplatten (6, 7) für Bedieneinheit (2) und Geräteeinheit (3)
zugeordnet ist.

7. Installationsgerät nach Anspruch 6, d a d u r c h
g e k e n n z e i c h n e t, daß an den Abdeckplatten
(6, 7) abstehende federnde Zungen (19) angeformt sind,
die unbelastet über die Auflagefläche der Abdeckplatten
vorstehen, mit denen die Abdeckplatten auf dem Abdeckrahmen (5) aufliegen.

8. Installationsgerät nach Anspruch 1, d a d u r c h
g e k e n n z e i c h n e t, daß die Bedieneinheit (2)
aus einer Frontplatte mit Bedienelementen nach Art von
Drucktasten (23) und/oder Schiebern besteht, die mit
angeformten federnden Haltearmen (24) eine Platine (25)
in zugeordneten Ausnehmungen (26) hält, auf der den
Bedienelementen zugeordnete mechanisch-elektrische
Wandlerelemente (27) angeordnet sind.

9. Installationsgerät nach Anspruch 1, d a d u r c h
g e k e n n z e i c h n e t, daß die Tragarme (8) mit Halterungen für mehr als einen modulartigen Bauelementeträger (9) versehen sind, wobei die Halterungen Führungsdorne (30) und/oder Greifnoppen (31) bilden.

FIG 1

FIG 2

FIG 3

FIG 5

FIG 4

FIG 6

0151269

84 P 3021

FIG 7

FIG 8

FIG 9

FIG 10

FIG 11

FIG 12

FIG 13

FIG 14

Europäisches
Patentamt

**EUROPÄISCHER RECHERCHENBERICHT**

**0151269**
Nummer der Anmeldung

EP 84 11 5057

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl 4) |
|---|---|---|---|
| X | FR-A-1 332 148 (BERKER JUNG)<br><br>* Seite 1, rechte Spalte, Absätze 8,9; Seite 2, linke Spalte, Absätze 1-3; Figuren 1-4 * | 1,2,4,6 | H 05 K 7/02<br>H 02 B 1/10 |
| Y | | 3,5,7 | |
| | --- | | |
| Y | FR-A-2 082 120 (LEGRAND)<br>* Seite 3, Zeile 39 - Seite 5, Zeile 33; Seite 6, Zeile 18 - Seite 7, Zeile 23; Seite 7, Zeile 36 - Seite 8, Zeile 31; Figur 1 * | 3,5 | |
| A | | 1 | |
| | --- | | RECHERCHIERTE SACHGEBIETE (Int. Cl.4) |
| Y | FR-A-2 007 269 (STOTZ)<br>* Seite 1, Zeilen 1-3,18-22; Seite 2, Zeilen 31-41 * | 7 | |
| | --- | | H 02 B 1/00<br>H 02 G 3/00 |
| A | US-A-3 707 697 (IZUMI)<br>* Spalte 2, Zeilen 10-19; Figuren 1,2 * | 1,4,8 | H 05 K 7/00<br>H 04 B 3/00 |
| | --- | | |
| A | BBC-NACHRICHTEN, Band 60, Nr. 11, 1978, Seiten 503-506, Mannheim, DE; R. ZAPP: "Wechselsprechanlage Busch Infoton im Installationssystem"<br>* Seite 503, Spalte 2; Figuren 1,2 * | 1,4,8 | |
| | ----- | | |

Der vorliegende Recherchenbericht wurde für alle Patentansprüche erstellt.

| Recherchenort<br>DEN HAAG | Abschlußdatum der Recherche<br>18-04-1985 | Prüfer<br>TIELEMANS H.L.A. |
|---|---|---|